# EUROPEAN PATENT SPECIFICATION

(11) **EP 0 355 610 B1**
(45) Date of publication and mention of the grant of the patent: **11.01.1995**
(21) Application number: 89114862.9
(22) Date of filing: 11.08.1989
(51) Int. Cl.: G02B 6/42, H01S 3/025, H01L 31/0203, H01L 33/00

(54) **An optical module**
Optisches Modul
Module optique

(30) Priority: 24.08.1988 JP 210119/88
(43) Date of publication of application: 28.02.1990
(73) Proprietor: SUMITOMO ELECTRIC INDUSTRIES, LTD., Osaka-shi, Osaka 541 (JP)
(72) Inventor: Shiga, Nobuo c/o Yokohama Works, Sakae-ku Yokohama-shi Kanagawa (JP)
(74) Representative: Kahler, Kurt, Dipl.-Ing.

(56) References cited:
- EP-A- 0 184 747
- EP-A- 0 216 699
- GB-A- 2 173 917
- JOURNAL OF LIGHTWAVE TECHNOLOGY, vol. LT-5, no. 10, October 1987, pages 1403-1411, New York, US; H. NAKANO et al.: "Dual-in-line laser diode module for fiber-optic transmission up to 4 Gbit/s".
- PATENT ABSTRACTS OF JAPAN, vol. 11, no. 7 (E-469)[2454], 9th January 1987;& JP-A-61 183 948
- D.R. Smith et al, "p-i-n/F.E.T. hybrid optical receiver for longer-wavelength optical communication systems", Electronics Letters, vol. 16, no. 2, pp. 69-71, Jan. 1980

## Description

The present invention relates to an optical module as described in the precharacterizing part of claim 1. Such an optical module can be used with an optical communication system such as a data link or an optical LAN which uses light as an information transmission medium.

In a known optical module, a semiconductor laser or a light emitting diode, which is a light emitting element, or a PIN photodiode which is a light detecting element is mounted as an optical unit, which is optically coupled with an optical fiber in a package. However, a response frequency band of the known optical module is not sufficiently high.

D.R. Smith et al, "p-i-n/F.E.T. hybrid optical receiver for longer-wavelength optical communication systems", Electronics Letters, vol. 16, no. 2, pp. 69 - 71, Jan. 1980 disclose an optical module comprising a p-i-n photodiode which is hybrid-integrated with other components on a thick-film circuit and mounted in a metal package. The end of an optical fiber reflects the light onto an active area of the photodiode. The bias supply to the photodiode is provided via a conductive pad on a substrate, to which the photodiode or its carrier is bonded, but the high frequency signal connection is made via a direct wire bond connection to an amplifier.

EP-A-0 216 699 discloses a microwave circuit with low parasitic capacities. To this end, a grounding plane provided for an unbalanced microstrip line is partially removed in order to diminish the capacity caused between a conductive area and the grounding plane, i. e. diminishing of the capacity is directed only to a microwave circuit having a grounding plane.

It is an object of the present invention to provide an optical module having a sufficiently high response frequency band while maintaining a compact design and a simple structure.

This object is solved by the features described in claim 1. Particular embodiments are set out in the dependent claims 2 to 4.

The present invention will become more fully understood from the detailed description given hereinbelow and the accompanying drawings in which:
Fig. 1 is a perspective view showing a main part of an optical module in accordance with one embodiment of the present invention,
Fig. 2 is a sectional view taken along a line II-II of Fig. 1,
Fig. 3 is a perspective view illustrating a manner of die-bonding of a chip carrier to a hybrid IC substrate, and
Fig. 4 is a circuit diagram of a light receiver which uses a PIN photodiode.

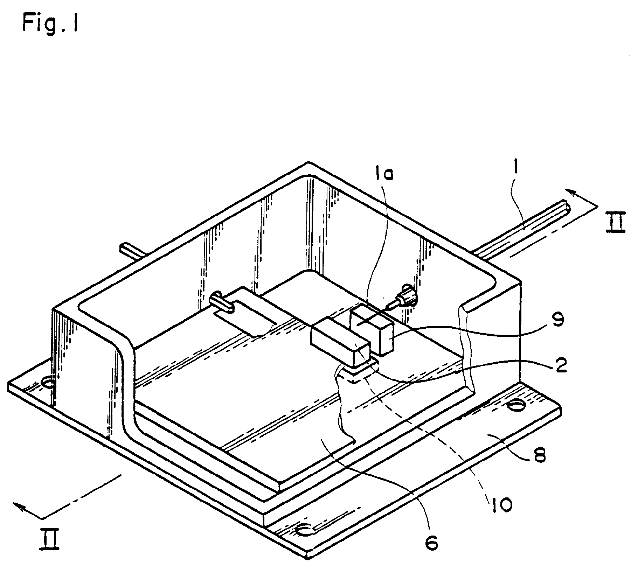

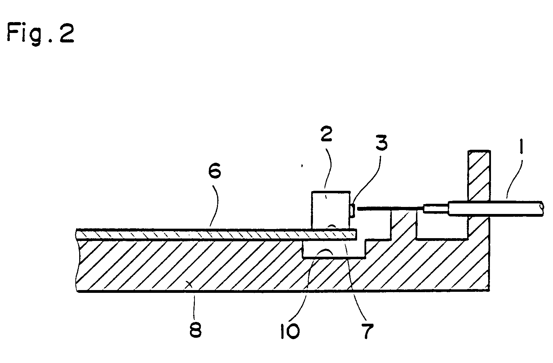

As shown in Figs.1 and 2, a hybrid IC substrate 6 made of ceramics is mounted on an inner bottom of a package 8 made of metal. A chip carrier 2 is mounted on the hybrid IC substrate 6.

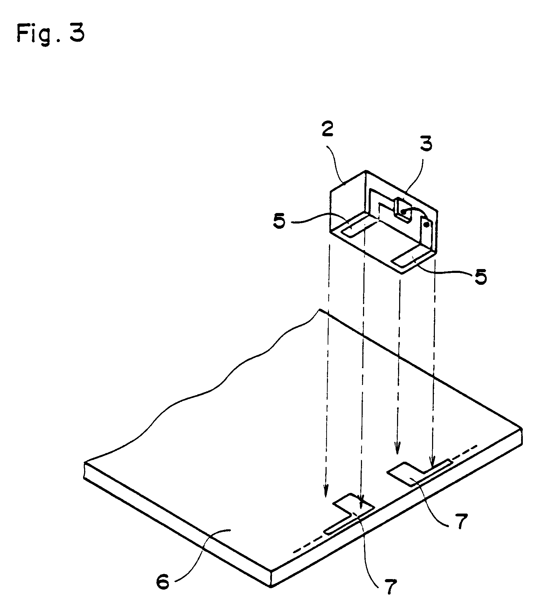

As shown in Fig. 3, the chip carrier 2 is of parallelepiped and made of ceramics. A PIN photodiode 3 is mounted on a front plane of the chip carrier 2. Two terminals 5 which are to be connected to an anode and a cathode of the PIN photodiode 3 on the chip carrier 2 are formed to extend from the front plane to a bottom plane. Those terminals 5 are formed by metallizing selected surface areas of the chip carrier 2. On the other hand, two conductive regions 7 which serve as electrodes are formed on a surface of the hybrid IC substrate 6. The terminals 5 of the chip carrier 2 are die-bonded to the conductive regions 7. The regions 7 are designed to have wider areas than the terminals 5 assuming possible misalignment in mounting the chip carrier 2. With present technique, the area of the conductive regions 7 is in the order of 1mm × 2mm at minimum.

The PIN photodiode 3 mounted on the chip carrier 2 faces a leading end plane of an optical fiber 1 in a package 8. The leading end of the optical fiber 1 is inserted into the package 8 through an opening formed on a side wall of the package 8. A cover of the optical fiber 1 is striped off at the leading end thereof so that a glass fiber is exposed. The exposed area is metal-plated except for the leading end plane. The metal-plated area 1a is positioned on a fixed member 9 mounted on the bottom of the package 8 and fixed thereto by soldering. The metal-plated area 1a of the optical fiber 1 is positioned such that a light emitted from the leading end plane of the optical fiber 1 is sufficiently directed to a photo-sensing area of the PIN photodiode 3. In this manner, the optical fiber 1 and the PIN photodiode 3 are optically coupled.

A recess 10 is formed at the inner bottom of the package 8. The recess 10 is formed at a position which faces the conductive regions 7 with the intervention of the hybrid IC substrate 6 when the hybrid IC substrate 6 is mounted in the package 8. Thus, the conductive regions 7 and the bottom of the package 8 are separated from each other by a space. The recess 10 serves to render a capacitance of a parallel-plate capacitor, which is essentially formed by the conductive regions 7 and the bottom of the package 8, negligibly small.

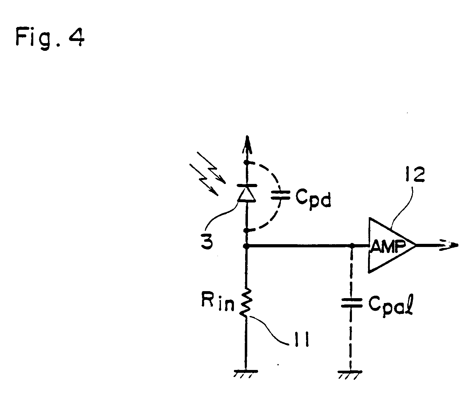

The parallel-plate capacitor which is essentially formed by the conductive regions 7 and the bottom of the package 8 is now explained. Fig. 4 shows an embodiment of a light receiver which uses the PIN photodiode 3. The parallel-plate capacitor formed by the conductive regions 7 and the bottom of the package 8 function as an input capacitance Cₚₐₗ of an amplifier 12. A response frequency band of the light receiver is determined by a time constant T which is determined by a resistance Rᵢₙ of an input resistor 11, a junction capacitance C_{pd} of the PIN photodiode 3 and the input capacitance Cₚₐₗ. As the time constant T increases, amount of information per unit time decreases. The time constant T is given by${\text{T=(C}}_{\text{pd}} {\text{+C}}_{\text{pal}} \text{)·Rin}$
The junction capacitance C_{pd} of the PIN photodiode 3 used for high speed optical communication is very small, usually in the order of 0.3 ∼ 0.4 pF. Accordingly, the affect of the input capacitance Cₚₐₗ to the time constant T is very great and it should be as small as possible.

If the recess 10 is not formed, the capacitance Cₚₐₗ of the parallel-plate capacitor is 0.46 pF assuming that the area of the conductive region 7 is 1mm × 2mm, a dielectric constant ε of the hybrid IC substrate 6 is 9, and a thickness thereof is 350 µm, and it is 0.25 pF assuming that the thickness of the hybrid IC substrate 6 is 650 µm. This capacitance is substantially equal to or larger than the capacitance of C_{pd} (0.3 ∼ 0.4 pF). It is thus seen that the affect to the time constant T is very great.

In the optical module of the present embodiment, since the recess 10 is formed in the inner bottom of the package 8, the capacitance of the parallel-plate capacitor formed by the conductive regions 7 and the bottom of the package 8 is small enough to permit neglection of the input capacitance Cₚₐₗ of the amplifier 12. As a result, the time constant T of the light receiver is reduced and the response frequency band is increased.

This embodiment is a receiving optical module which uses the PIN photodiode 3 as the optical unit which is optically coupled to the optical fiber 1. The same problem is encountered in a transmitting optical module which uses a light emitting element such as LED or laser diode as the optical unit, and the present invention is also applicable to such a transmitting optical module.

## Claims

1. An optical module comprising:
a metallic package (8);
a substrate (6) provided on the bottom of the metallic package (8); and
an optical unit (3) optically coupled with an end of an optical fiber (1) which extends into the package (8);
**characterized** in
- that there is provided a chip carrier (2) on which the optical unit (3) is mounted and electrical terminals (5) of the optical unit are formed, said electrical terminals (5) being die-bonded to conductive regions (7) formed on the substrate (6); and
- that an area of the opposite side of the substrate (6) opposite to said conductive regions (7) is spaced from said bottom of said package (8).

2. An optical module according to claim 1, wherein the bottom of said package has a recess (10) to space said area from the bottom of the package (8).

3. An optical module according to claim 1 or 2, wherein said optical unit is a photo-detecting element (3).

4. An optical module according to claim 1 or 2, wherein said optical unit is a light emitting element.

## Patentansprüche

1. Ein optisches Modul mit
einem Gehäuse (8) aus Metall;
einem Substrat (6), das an dem Boden des Gehäuses (8) aus Metall vorgesehen ist; und
einer optischen Einheit (3), die mit einem Ende eines sich in das Gehäuse (8) erstreckenden Lichtleiters (1) optisch gekoppelt ist;
dadurch **gekennzeichnet**,
- daß ein Chipträger (2) vorgesehen ist, an dem die optische Einheit (3) befestigt ist und elektrische Klemmen (5) der optischen Einheit ausgebildet sind, wobei die elektrischen Klemmen (5) mittels Chip-Bondens mit an dem Substrat (6) ausgebildeten leitfähigen Bereichen (7) verbunden sind, und
- daß ein Bereich der gegenüberliegenden Seite des Substrats (6), der den leitfähigen Bereichen (7) gegenüberliegt, von dem Boden des Gehäuses (8) beabstandet ist.

2. Ein optisches Modul nach Anspruch 1,
wobei der Boden des Gehäuses eine Aussparung (10) derart aufweist, daß der Bereich von dem Boden des Gehäuses (8) beabstandet ist.

3. Ein optisches Modul nach Anspruch 1 oder 2,
wobei die optische Einheit ein lichterfassendes Element (3) ist.

4. Ein optisches Modul nach Anspruch 1 oder 2,
wobei die optische Einheit ein lichtaussendendes Element ist.

## Revendications

1. Module optique comprenant :
un boîtier métallique (8),
un substrat (6) placé sur le fond du boîtier métallique (8), et
une unité optique (3) optiquement couplée à une extrémité d'une fibre optique (1) qui rentre dans le boîtier (8),
caractérisé en ce que
il est prévu un support de puce (2) sur lequel l'unité optique (3) est montée et les bornes électriques (5) de l'unité optique sont formées, lesdites bornes électriques (5) étant collées par estampage à des régions conductrices (7) formées sur le substrat (6), et
en ce que une surface opposée auxdites régions conductrices (7) du côté opposé du substrat (6) est espacée dudit fond dudit boîtier (8).

2. Module optique selon la revendication 1, dans lequel le fond dudit boîtier comporte un évidement (10) pour espacer ladite surface du fond du boîtier (8).

3. Module optique selon la revendication 1 ou 2, dans lequel l'unité optique est un élément de détection photo-électrique (3).

4. Module optique selon la revendication 1 ou 2, dans lequel ladite unité optique est un élément émettant de la lumière.
